# DEMANDE DE BREVET EUROPEEN

(11) **EP 2 915 897 A1**
(43) Date de publication de la demande: **09.09.2015**
(21) Numéro de dépôt: 15305308.7
(22) Date de dépôt: 27.02.2015
(51) Int. Cl.: C23C 14/24, C23C 14/54, C23C 14/56, C23C 14/26

(54) **Procédé de rechargement d'une cellule d'évaporation**

(30) Priorité: 03.03.2014 FR 1451712
(71) Demandeur: RIBER, 95873 Bezons Cedex (FR)
(72) Inventeur: Esteve, David, 78380 Bougival (FR); Stemmelen, Franck, 95490 Vaureal (FR); de Oliveira, Christophe, 78400 Chatou (FR)
(74) Mandataire: Coralis Harle

(57) **Abrégé**

La présente invention concerne un procédé de rechargement d'une cellule d'évaporation (10) destinée à évaporer un matériau (7) sur un substrat placé dans une chambre de dépôt sous vide, un premier creuset (110) contenant le matériau à évaporer étant engagé avec une chambre d'évaporation (100) de la cellule d'évaporation, et des moyens d'évaporation (101, 131, 132) étant prévus pour mettre le premier creuset en conditions d'évaporation pour générer un flux de vapeur (116) du matériau.

Ce procédé de rechargement comporte une étape de chargement d'un deuxième creuset (120) contenant le matériau à évaporer dans une chambre de chargement (200) préalablement isolée de la chambre d'évaporation attenante, la pression dans la chambre de chargement étant alors sensiblement supérieure à celle dans la chambre de dépôt sous vide ; une étape de confinement destinée à ramener la pression à l'intérieur de la chambre de chargement à un niveau comparable à celui de la chambre d'évaporation lors de l'évaporation du premier creuset ; une étape de libération lors de laquelle le premier creuset est transféré vers la chambre de chargement, une étape d'engagement du deuxième creuset avec la chambre d'évaporation, et une étape de mise en conditions d'évaporation du deuxième creuset.

## Description

L'invention concerne le domaine de l'évaporation et du dépôt sous vide de matériaux sur un substrat.

L'invention concerne plus particulièrement un procédé de rechargement d'une cellule d'évaporation destinée à évaporer un matériau en vue de son dépôt sur un substrat placé dans une chambre de dépôt sous vide.

Un appareil de dépôt sous vide permet de déposer un matériau, tel qu'un matériau ou composé semi-conducteur (par exemple : silicium, arséniure de gallium, phosphure d'indium, *etc...),* un matériau inorganique (par exemple : sélénium, antimoine, phosphore), ou un matériau organique (par exemple : tris (8-hydroxyquinoléine) aluminium (III) ou Alq3, ...), évaporé au sein d'une chambre d'évaporation, sur un substrat placé dans une chambre de dépôt maintenue sous vide.

Un tel appareil comporte en particulier une cellule d'évaporation destinée à évaporer le matériau, un premier creuset contenant le matériau à évaporer étant alors engagé avec la chambre d'évaporation de ladite cellule d'évaporation, des moyens d'évaporation étant prévus pour mettre ce premier creuset en conditions d'évaporation pour générer un flux de vapeur du matériau au travers d'un orifice de sortie de la chambre d'évaporation, l'orifice de sortie étant raccordé à un injecteur pour l'injection de la vapeur dans la chambre de dépôt sous vide.

Pour assurer une production *quasi* continue, on peut exploiter une cellule d'évaporation utilisant un creuset de grande capacité contenant une grande quantité de matériau à évaporer, de sorte qu'il est alors possible de déposer le matériau sur un grand nombre de substrats successifs.

Cependant, en utilisant des creusets de grande capacité, il est nécessaire lors de leur remplacement d'attendre leur refroidissement avant de pouvoir recharger la cellule d'évaporation afin que la stabilité thermique de la chambre d'évaporation ne soit pas perturbée par le retrait d'un creuset chaud et l'introduction d'un creuset froid dans la chambre d'évaporation.

Ainsi, le rechargement de la cellule d'évaporation conduit à une interruption longue de la production, un nouveau creuset ne pouvant être préparé pour son évaporation avant d'avoir pu libérer le premier creuset de la cellule d'évaporation.

Cette interruption de production, pouvant aller de quelques heures à plusieurs jours en fonction de la taille des creusets, réduit le rendement de production et augmente le coût de l'opération de dépôt du matériau sur le substrat.

Pour assurer une production continue, on pourrait également utiliser un appareil de dépôt sous vide tel que décrit dans le document WO 2006/001205 comportant deux cellules d'évaporation séparées.

Néanmoins, l'intégration de plusieurs cellules d'évaporation sur un même appareil de dépôt sous vide est complexe et coûteuse.

Afin de remédier à l'inconvénient précité de l'état de la technique, la présente invention propose un procédé de rechargement d'une cellule d'évaporation permettant de réduire, voire de supprimer, les temps d'interruption d'un procédé de dépôt mis en oeuvre par un appareil de dépôt sous vide utilisant cette cellule d'évaporation.

À cet effet, l'invention concerne un procédé de rechargement d'une cellule d'évaporation destinée à évaporer un matériau en vue de son dépôt sur un substrat placé dans une chambre de dépôt maintenue sous vide, un premier creuset contenant ledit matériau à évaporer étant engagé avec une chambre d'évaporation de ladite cellule d'évaporation, des moyens d'évaporation étant prévus pour mettre ledit premier creuset en conditions d'évaporation pour générer un flux de vapeur du matériau au travers d'un orifice de sortie de ladite chambre d'évaporation, ledit orifice de sortie étant raccordé à un injecteur pour l'injection de ladite vapeur dans ladite chambre de dépôt sous vide, ledit procédé de rechargement comportant :
- une étape de chargement d'un deuxième creuset contenant le matériau à évaporer dans une chambre de chargement préalablement isolée de ladite chambre d'évaporation attenante, la pression dans ladite chambre de chargement étant alors sensiblement supérieure à celle régnant dans la chambre de dépôt sous vide,
- après ladite étape d'introduction, une étape de confinement de ladite chambre de chargement destinée à ramener la pression à l'intérieur de ladite chambre de chargement à un niveau comparable à celui de ladite chambre d'évaporation lors de l'évaporation dudit premier creuset,
- après ladite étape de confinement, une étape de libération dudit premier creuset d'avec ladite chambre d'évaporation lors de laquelle ledit premier creuset est transféré de ladite chambre d'évaporation vers ladite chambre de chargement,
- après ladite étape de libération du premier creuset, une étape d'engagement dudit deuxième creuset avec ladite chambre d'évaporation, et
- après ladite étape d'engagement dudit deuxième creuset, une étape de mise en conditions d'évaporation dudit deuxième creuset pour générer un flux de vapeur du matériau au travers dudit orifice de sortie de la chambre d'évaporation.

Selon l'invention, lors de ladite étape d'engagement dudit deuxième creuset, on isole ladite chambre de chargement vis-à-vis de ladite chambre d'évaporation et de ladite chambre de dépôt sous vide.

Grâce à l'isolation obtenue par l'engagement du premier creuset avec la chambre d'évaporation, le procédé de rechargement selon l'invention permet avec une seule chambre d'évaporation et une seule chambre de chargement de changer rapidement de creuset sans interruption longue du procédé de dépôt.

En effet, grâce à ladite chambre de chargement préalablement isolée de ladite chambre d'évaporation, il est possible, avant l'étape de libération du premier creuset, de préparer le deuxième creuset pendant que le premier creuset est en cours d'évaporation dans la cellule d'évaporation.

Le procédé de rechargement est particulièrement adapté au cas où l'on utilise des creusets de petit volume nécessitant un remplacement fréquent de creuset.

Par ailleurs, d'autres caractéristiques avantageuses et non limitatives du procédé selon l'invention sont les suivantes :
- lors de ladite étape de chargement dudit deuxième creuset, on ouvre une trappe d'accès de ladite chambre de chargement et on introduit, depuis l'extérieur de ladite cellule d'évaporation, ledit deuxième creuset à l'intérieur de ladite chambre de chargement au travers de ladite trappe d'accès ;
- lors de ladite étape de confinement, on ferme ladite trappe d'accès de manière étanche vis-à-vis de l'extérieur de ladite cellule d'évaporation, et on réalise un pompage à l'intérieur de ladite chambre de chargement ;
- lors de ladite étape de libération du premier creuset, on retire ledit premier creuset de ladite chambre d'évaporation en le faisant passer au travers d'une ouverture d'insertion mettant en communication ladite chambre de chargement et ladite chambre d'évaporation, et lors de ladite étape d'engagement dudit deuxième creuset, on insère ledit deuxième creuset dans ladite chambre d'évaporation en le faisant passer au travers de ladite ouverture d'insertion, et on obture ladite ouverture d'insertion de manière étanche pour isoler ladite chambre de chargement de ladite chambre d'évaporation ;
- ledit procédé de rechargement comporte avant ladite étape d'engagement dudit deuxième creuset avec ladite chambre d'évaporation, une étape de préparation dudit deuxième creuset dans ladite chambre de chargement destinée à réduire la durée de ladite étape de mise en conditions d'évaporation dudit deuxième creuset ;
- ladite étape de préparation comprend une étape de préchauffage dudit deuxième creuset dans ladite chambre de chargement, jusqu'à une température de préchauffage prédéterminée.

Des modes de réalisation de l'invention seront décrits en détail en référence aux dessins dans lesquels :
- la figure 1 est une vue schématique d'ensemble en coupe dans un plan vertical d'un appareil de dépôt sous vide selon un mode de réalisation de l'invention comportant une cellule d'évaporation et une chambre de dépôt sous vide ;
- la figure 2A est une vue schématique en coupe dans un plan vertical d'un premier exemple de cellule d'évaporation comportant une chambre d'évaporation avec laquelle un premier creuset plein est engagé, et une chambre de chargement attenante comprenant un creuset vide ;
- la figure 2B est une vue de détail de la zone II de la figure 2A ;
- la figure 3 est une vue schématique en coupe dans un plan vertical de la cellule d'évaporation de la figure 2A lors du chargement initial de la chambre de chargement avec un deuxième creuset plein ;
- la figure 4 est une vue schématique en coupe dans un plan vertical de la cellule d'évaporation de la figure 2A lors de l'évaporation du premier creuset ;
- la figure 5 est une vue schématique en coupe dans un plan vertical de la cellule d'évaporation de la figure 2A avant libération du premier creuset vide d'avec la chambre d'évaporation ;
- la figure 6 est une vue schématique en coupe dans un plan vertical de la cellule d'évaporation de la figure 2A après libération du premier creuset vide d'avec la chambre d'évaporation ;
- la figure 7 est une vue schématique en coupe dans un plan vertical de la cellule d'évaporation de la figure 2A avant engagement du deuxième creuset plein avec la chambre d'évaporation ;
- la figure 8 est une vue schématique en coupe dans un plan vertical de la cellule d'évaporation de la figure 2A après engagement du deuxième creuset avec la chambre d'évaporation, lors de l'étape de mise en condition du deuxième creuset ;
- la figure 9A est une vue schématique en coupe dans un plan vertical d'un deuxième exemple de cellule d'évaporation ;
- la figure 9B est une vue de détail de la zone IX de la figure 9A montrant les moyens d'obturation d'une ouverture d'insertion entre la chambre d'évaporation et la chambre de chargement de la cellule d'évaporation de la figure 9A ;
- la figure 10 est une vue schématique d'un troisième exemple de cellule d'évaporation comportant une vanne étanche entre la chambre d'évaporation et l'injecteur ;
- la figure 11 est une vue schématique d'une variante du troisième exemple de la cellule d'évaporation de la figure 10 dans laquelle l'enceinte externe de la chambre d'évaporation est isolée de la chambre de dépôt sous vide ;
- la figure 12 est une vue schématique d'un quatrième exemple de cellule d'évaporation comportant deux chambres d'évaporation distinctes.

Dans l'exposé qui va suivre, les termes « haut » et « bas » seront utilisés par référence à la verticale, relativement au local dans lequel l'appareil de dépôt sous vide est installé, le haut désignant le côté tourné vers le plafond du local et le bas désignant le côté tourné vers le plancher. De même, les termes « inférieur » et « supérieur » désigneront les côtés tournés respectivement vers le bas et vers le haut.

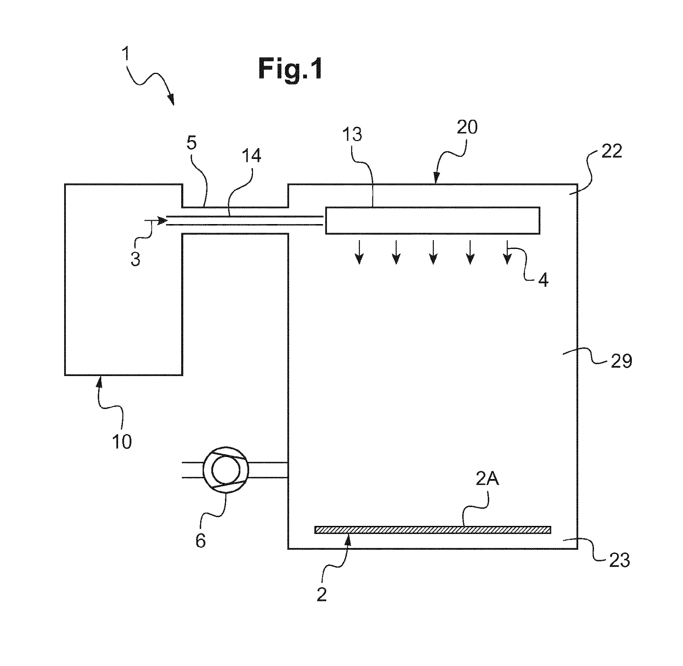

On a représenté sur la figure 1 une vue schématique d'ensemble en coupe dans un plan vertical d'un appareil de dépôt sous vide 1 qui comporte, d'une part, une cellule d'évaporation 10, et, d'autre part, une chambre de dépôt sous vide 20.

De manière générale, la cellule d'évaporation 10 de l'appareil de dépôt sous vide 1 est destinée à évaporer un matériau en vue de son dépôt sur un substrat 2 placé dans la chambre de dépôt sous vide 20, ici dans une partie basse 23 de celle-ci.

On verra dans la suite de la description que la cellule d'évaporation 10 est conçue pour générer un flux de vapeur amont 3 dudit matériau, flux de vapeur amont 3 qui est transporté par un conduit d'injection 14 depuis la cellule d'évaporation 10 jusqu'à un injecteur 13 situé dans la partie haute 22 de la chambre de dépôt sous vide 20.

La cellule d'évaporation 10 et la chambre de dépôt sous vide 20 sont connectées l'une à l'autre par un raccord tubulaire 5 traversé par le conduit d'injection 14.

L'injecteur 13 de la cellule d'évaporation 10 injecte la vapeur de matériau transportée par le conduit d'injection 14 dans la chambre de dépôt sous vide 20 selon un flux de vapeur aval 4 dirigé vers le bas en direction du substrat 2, de sorte que le matériau se dépose sur une face supérieure 2A du substrat 2 tournée vers l'injecteur 13.

L'injecteur 13 est conçu pour optimiser les caractéristiques du flux de vapeur aval 4 dirigé vers le substrat 2, par exemple son débit ou sa distribution spatiale, de sorte que la couche de matériau déposée sur la face supérieure 2A du substrat 2 présente les propriétés requises comme l'épaisseur, l'état de surface, la conductivité, etc..., en fonction de l'application visée.

Il est prévu à l'intérieur de l'injecteur 13 des moyens spécifiques de chauffage (non représentés) destinés à éviter la condensation des vapeurs de matériau à l'intérieur de l'injecteur 13, ce qui pourrait compromettre son bon fonctionnement.

Afin de réaliser et de maintenir le vide à l'intérieur de la chambre de dépôt sous vide 20, l'appareil de dépôt sous vide 1 comporte des moyens de pompage 6 branchés sur la chambre de dépôt sous vide 20 dont les capacités de pompage sont ajustées en fonction du volume intérieur 29 de la chambre de dépôt sous vide 20.

Ces moyens de pompage 6 comprennent ici une pompe turbo-moléculaire ou bien une pompe cryogénique qui font descendre le niveau de pression régnant à l'intérieur de la chambre de dépôt sous vide 20 jusqu'à 10⁻³ à 10⁻⁸ Torr.

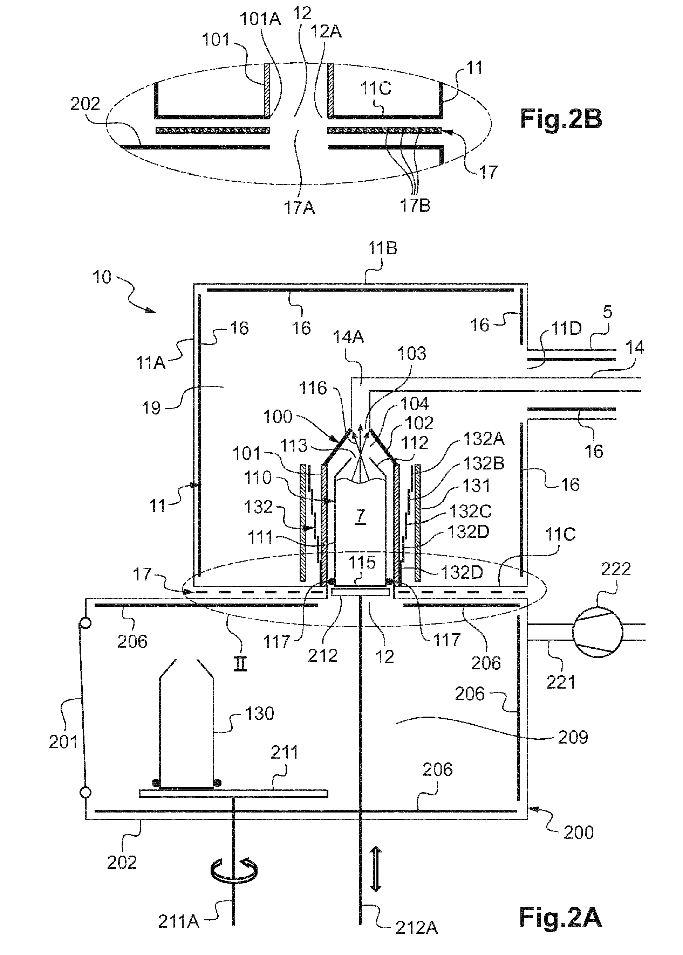

On va maintenant décrire en référence aux figures 2 à 9B, un premier exemple de cellule d'évaporation 10 destinée à produire un flux de vapeur aval 3 en direction de l'injecteur 13. On décrira également un procédé de rechargement selon l'invention permettant d'exploiter cette cellule d'évaporation 10 de manière quasi continue, c'est-à-dire en limitant les temps d'arrêt de la production du flux de vapeur aval 3.

Comme représenté sur la figure 2A, la cellule d'évaporation 10 de l'appareil de dépôt sous vide 1 comporte tout d'abord une enceinte externe 11, ici de forme globalement cylindrique, comprenant une paroi latérale 11A, une paroi supérieure 11 B (ou *« toit »),* et une paroi inférieure 11C (ou *« fond »).*

Il est prévu, sur les faces internes de la paroi latérale 11A et de la paroi supérieure 11 B de l'enceinte externe 11, et aussi du raccord tubulaire 5, des éléments chauffants, par exemple des résistances chauffantes 16, destinés à chauffer de façon sensiblement homogène le volume intérieur 19 de l'enceinte externe 11, en particulier le conduit d'injection 14, de manière à éviter que les vapeurs de matériau ne se condensent sur des parties froides de la cellule d'évaporation 10.

Il est également prévu, cette fois sur les faces externes de la paroi latérale 11 A, de la paroi supérieure 11 B, et aussi du raccord tubulaire 5, des éléments refroidissants (non représentés), par exemple des serpentins d'eau froide, de sorte que l'enceinte externe 11 de la cellule d'évaporation 10 soit froide au toucher depuis l'extérieur.

Entre les éléments chauffants 16 et les éléments refroidissants, est inséré un écran radiatif, par exemple réalisé sous la forme d'un matériau réfractaire, de sorte que le chauffage et le refroidissement soient efficaces chacun de leur côté.

La paroi latérale 11A comprend une ouverture 11 D de laquelle s'étend vers l'extérieur le raccord tubulaire 5 pour la connexion de la cellule d'évaporation 10 avec la chambre de dépôt sous vide 20 de l'appareil de dépôt sous vide 1.

Dans cette configuration (commune aux figures 1 à 10 et 12), l'enceinte externe 11 et la chambre de dépôt sous vide 20 sont en communication et partagent le même vide si bien que lorsque le vide est fait à l'intérieur de la chambre de dépôt sous vide 20, il est également fait à l'intérieur de l'enceinte externe 11 de la cellule d'évaporation 10. Le niveau de pression dans cette enceinte externe 11 est ainsi égal à celui régnant dans la chambre de dépôt sous vide 20.

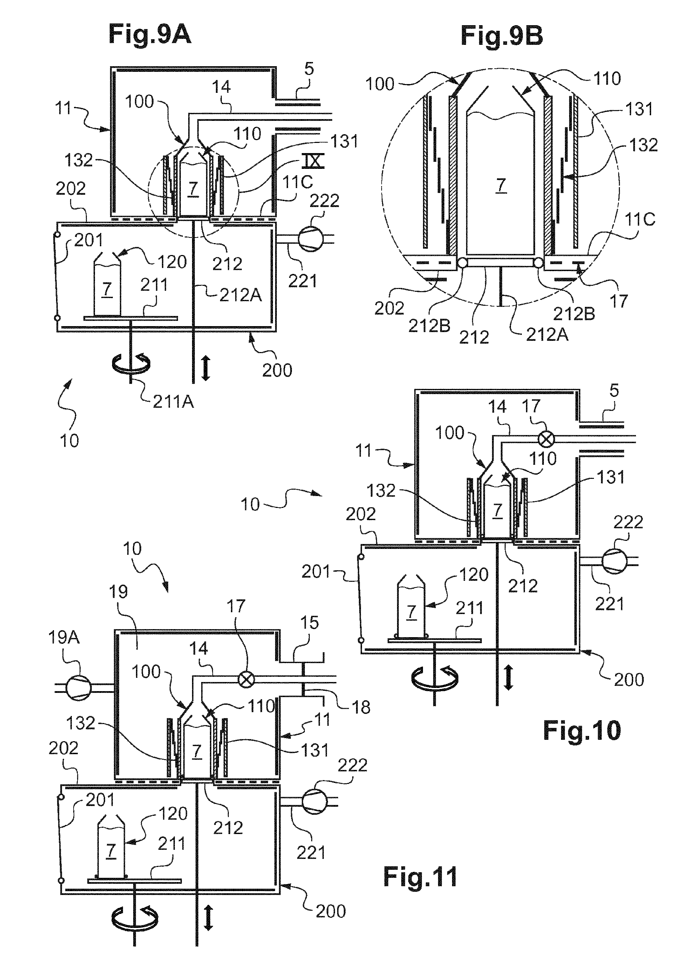

En variante, comme représenté sur la figure 11, on peut prévoir une soudure étanche 18 entre le raccord tubulaire 5 et le conduit d'injection 14 de la cellule d'évaporation 10, de sorte que l'enceinte externe 11 de la cellule d'évaporation 10 ne partage pas le même vide que la chambre de dépôt sous vide 20. Dans ce cas, la cellule d'évaporation 10 comprend alors une pompe d'enceinte 19A qui lui est dédiée et qui est destinée à pomper le volume intérieur 19 de l'enceinte externe 11 pour faire chuter la pression jusqu'à un niveau de l'ordre de 10⁻² à 10⁻³ Torr.

Comme cela est visible sur les figures 2A et 2B, une ouverture, appelée par la suite ouverture d'insertion 12, est découpée dans la paroi inférieure 11C de l'enceinte externe 11.

Cette ouverture d'insertion 12 présente un bord intérieur 12A, qui est ici de forme circulaire, au-dessus duquel s'étend, vers l'intérieur de l'enceinte externe 11, une chambre d'évaporation 100 de la cellule d'évaporation 10.

Cette chambre d'évaporation 100 est délimitée par une paroi étanche comprenant, d'une part, un corps 101 cylindrique coaxial avec l'ouverture d'insertion 12, et, d'autre part, un col 102 tronconique prolongeant le corps 101, jusqu'à un orifice de sortie 103 de la chambre d'évaporation 100.

Ce corps 101 de la chambre d'évaporation 100 présente un bord inférieur 101 A qui court sans interruption le long du bord intérieur 12A de l'ouverture d'insertion 12. Le bord inférieur 101 A est hermétiquement fixé sur la paroi inférieure 11C de l'enceinte externe 11 de la cellule d'évaporation 10 de sorte que le volume intérieur 19 de l'enceinte externe 11 de la cellule d'évaporation 10 ne communique pas avec le volume intérieur 104 de la chambre d'évaporation 10.

L'orifice de sortie 103 de la chambre d'évaporation 100 est connecté de manière étanche au conduit d'injection 14 de la cellule d'évaporation 10 formant ici un coude 14A au niveau dudit orifice de sortie 103. La connexion étanche peut être réalisée, par exemple, au moyen d'une soudure.

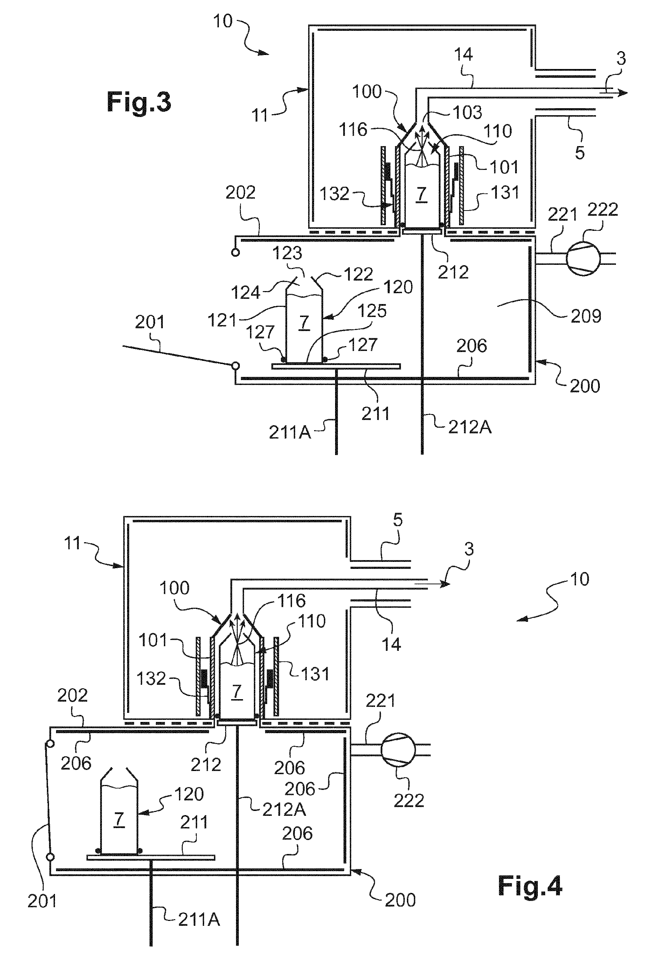

La chambre d'évaporation 100 de la cellule d'évaporation 10 est destinée à accueillir un creuset, tel que le premier creuset 110 (voir figure 2A) et le deuxième creuset 120 (voir figure 3). Ces creusets 110, 120 présentent des formes et des dimensions adaptées pour qu'ils puissent loger dans la chambre d'évaporation 100.

De manière avantageuse, les creusets 110, 120 présentent une capacité volumique faible, inférieure à 1 litre (L), de préférence inférieure à 0,5 L, par exemple égale à 0,33 L.

Ils présentent globalement la forme d'une bouteille et comprennent une paroi latérale 111, 121 qui est fermée vers le bas par un fond 115, 125 et qui se rétrécit vers le haut suivant un col 112, 122 délimitant un goulot 113, 123 du creuset 110, 120.

Les creusets 110, 120 sont de préférence réalisés d'une seule pièce dans un matériau présentant une bonne transparence aux infrarouges et une résistance aux hautes températures. Les creusets 110, 120 peuvent être, par exemple, réalisés dans un matériau céramique tel que le nitrure de bore pyrolytique ou PBN (pour *« Pyrolytic Boron Nitride » en* anglais) ou alors dans un matériau de type vitreux tel que le quartz.

Ils sont destinés à être remplis par le matériau 7 à évaporer, ce matériau 7 pouvant se présenter sous forme liquide, sous forme de poudre, voire sous forme de lingots.

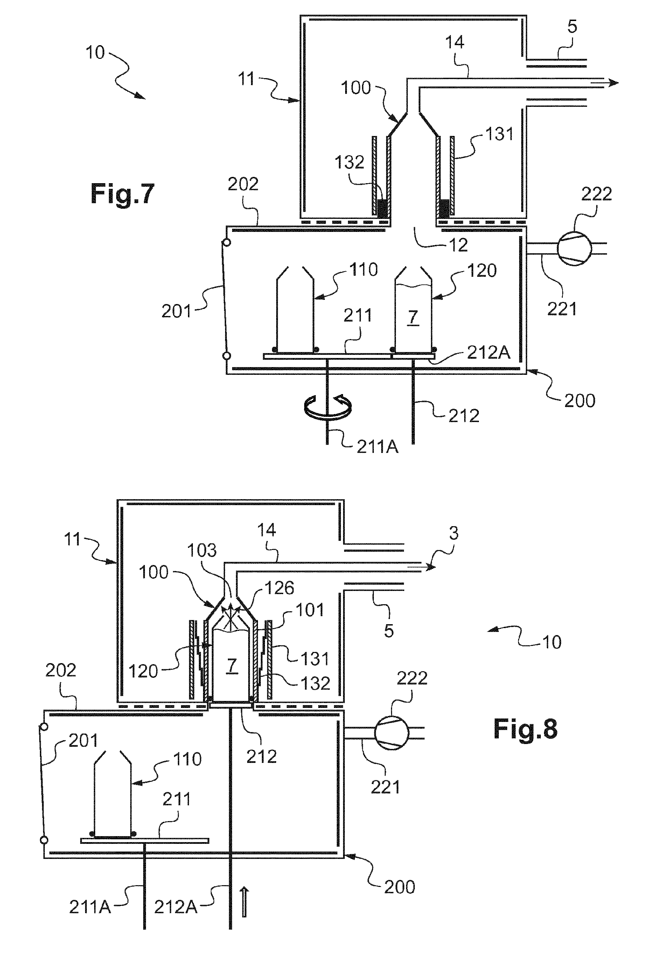

Lorsqu'un creuset (cas du premier creuset 110 sur la figure 3, cas du deuxième creuset 120 sur la figure 8) est engagé avec la chambre d'évaporation, c'est-à-dire lorsqu'il est logé à l'intérieur du volume intérieur 104 de la chambre d'évaporation 100, sa paroi latérale 111, 121 se retrouve alors en regard du corps 101 de la chambre d'évaporation 100.

Afin de mettre en conditions d'évaporation un creuset 110, 120 engagé avec la chambre d'évaporation 100, la cellule d'évaporation comporte également des moyens d'évaporation disposés à la périphérie de la chambre d'évaporation 100 accueillant ledit creuset 110, 120.

Dans tous les exemples décrits sur les figures 2 à 12, ces moyens d'évaporation comprennent tout d'abord des résistances électriques 131 entourant la chambre d'évaporation 100 et s'étendant depuis le fond 11C de l'enceinte externe 11, sensiblement parallèlement au corps 101 de la chambre d'évaporation 100, jusqu'au col 102 de celle-ci.

Ces résistances électriques 131 sont alimentées électriquement et portées à haute température de sorte qu'elles rayonnent de la chaleur, essentiellement sous forme infra-rouge.

En variante, les moyens d'évaporation peuvent comprendre des lampes infrarouges placées directement dans le volume intérieur de la chambre d'évaporation, contre le corps de celle-ci, de manière à irradier directement le creuset engagé dans la chambre d'évaporation.

Les moyens d'évaporation comprennent également un écran thermique 132 situé à l'intérieur de l'enceinte externe 11 et interposé entre le corps 101 de la chambre d'évaporation 100 et les résistances électriques 131.

Comme le montre bien la figure 9B, cet écran thermique 132 est de type « télescopique » et comporte ici cinq éléments mobiles 132A, 132B, 132C, 132D, 132E, cylindriques et coaxiaux, qui peuvent s'emboîter les uns dans les autres de sorte que la hauteur de l'écran thermique 132 peut être ajustée à façon.

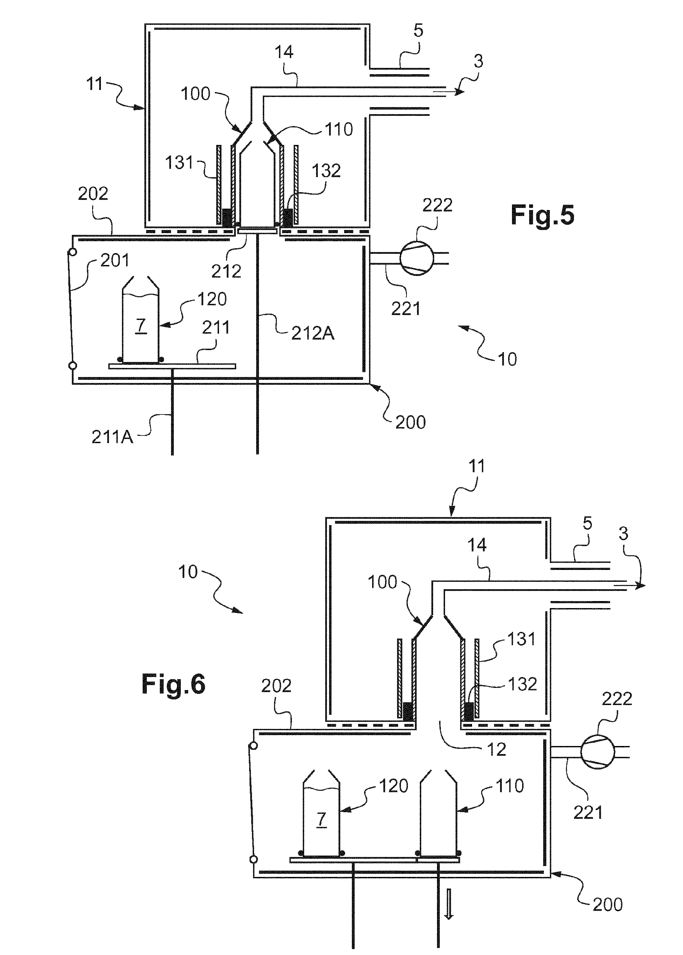

Par exemple, la figure 2A fait apparaître l'écran thermique 132 selon sa plus grande hauteur, lorsque tous les éléments mobiles 132A, 132B, 132C, 132D, 132E sont dépliés. La figure 6, quant à elle, fait apparaître l'écran thermique 132 230 lorsque tous les éléments mobiles 132A, 132B, 132C, 132D, 132E sont emboîtés les uns dans les autres.

Les éléments mobiles 132A, 132B, 132C, 132D, 132E sont ici formés de cylindres réalisés dans le même matériau, par exemple un matériau métallique, tel que l'acier ou l'aluminium.

En variante, les éléments mobiles peuvent être par exemple constitués de cylindres en quartz, en verre ou en silice, dont la face externe tournée vers les résistances électriques est revêtue d'une couche réfléchissant le rayonnement thermique émis par ces résistances électriques, par exemple une couche métallique, telle qu'une couche d'argent, d'aluminium, ou bien d'or.

Les moyens d'évaporation comportent par ailleurs des moyens d'actionnement permettant de faire coulisser les éléments mobiles 132A, 132B, 132C, 132D, 132E les uns par rapport autres pour régler la hauteur de l'écran thermique 132.

Bien que sur les figures 2 à 12 les éléments mobiles 132A, 132B, 132C, 132D, 132E soient au nombre de cinq et présentent tous la même hauteur, on peut envisager en variante que les moyens d'évaporation comprennent plus ou moins d'éléments mobiles et que ceux-ci présentent des hauteurs différentes. Cela peut notamment être avantageux afin d'adapter la hauteur de l'écran thermique à la hauteur de la chambre d'évaporation et de régler cette hauteur avec plus ou moins de précision.

Les moyens d'évaporation comportent enfin ici le corps 101 cylindrique de la chambre d'évaporation 100 qui comprend une paroi transparente qui est choisie de manière à transmettre le rayonnement infra-rouge émis par les résistances électriques 131.

Dans les conditions de pression régnant à l'intérieur de l'enceinte externe 11, les échanges de chaleur entre les résistances électriques 131 et le corps 111, 121 d'un creuset 110, 120 engagé avec la chambre d'évaporation 100 se font essentiellement par rayonnement, car les échanges par convection sont fortement limités du fait du vide régnant l'enceinte externe 11.

La paroi transparente peut être par exemple formée d'un cylindre creux en en quartz, en verre ou en silice, éventuellement revêtue d'une couche améliorant la transmission infra-rouge de la paroi transparente.

L'écran thermique 132, agencé entre les résistances électriques 131 et cette paroi transparente du corps 101 de la chambre d'évaporation 100, va ainsi agir comme un miroir pour la lumière infra-rouge rayonnée par les résistances électriques 131 en direction du corps 111, 121 d'un creuset 110, 120 se trouvant dans la chambre d'évaporation 100.

Ainsi, grâce à l'écran thermique 132, il est possible de découvrir tout ou partie des résistances électriques 131, de sorte que seule la fraction de matériau 7 contenue dans la partie supérieure 114, 124 des creusets 110, 120, soit soumise au rayonnement émis par les résistances électriques et soit chauffée, en fonction de la pression dans la chambre d'évaporation, jusqu'à une température de chauffage suffisante pour permettre son évaporation.

De plus, grâce aux moyens d'actionnement faisant coulisser les éléments mobiles 132A, 132B, 132C, 132D, 132E, il est possible de régler finement la hauteur de l'écran thermique 132 pour ajuster en temps réel le flux de vapeur 116, 126 (voir figures 4 et 8) au travers des goulots 113, 123 des creusets 110, 120.

En particulier, il est possible d'obtenir des conditions d'évaporation dans lesquelles le flux de vapeur 116, 126 demeure sensiblement constant tout au long de l'évaporation du matériau 7 contenu dans les creusets 110, 120. Ceci s'avère particulièrement intéressant pour le dépôt d'une couche uniforme sur le substrat 2 placé dans la chambre de dépôt sous vide 20.

Le flux de vapeur 116, 126 du matériau 7 généré grâce aux moyens d'évaporation 131, 132, 101 chauffant les creusets 110, 120 situés dans la chambre d'évaporation 100 passe alors au travers de l'orifice de sortie 103 de la chambre d'évaporation 100 et est ensuite transporté jusqu'à l'injecteur 13 le long du conduit d'injection 14 de la cellule d'évaporation 10, injecteur 13 qui, comme vu précédemment, génère le flux de vapeur amont 4 en direction du substrat 2 placé dans la chambre de dépôt sous vide 20.

Comme représenté sur les figures 2 à 12, la cellule d'évaporation 10 comporte également une chambre de chargement 200 attenante à la chambre d'évaporation 100 et située ici en-dessous de l'enceinte externe 11 de la cellule d'évaporation 10.

Cette chambre de chargement 200 est délimitée par une enceinte de confinement 202 et comporte une trappe d'accès 201 permettant :
- en position ouverte, de mettre le volume intérieur 209 de la chambre de chargement 200 en communication avec l'extérieur de la cellule d'évaporation 10, par exemple avec le local dans lequel est entreposé l'appareil de dépôt sous vide 1, et
- en position fermée, d'isoler le volume intérieur 209 de la chambre de chargement 200 de l'extérieur de la cellule d'évaporation 10.

De manière avantageuse, on peut prévoir d'adjoindre à la chambre de chargement, en amont de celle-ci, un sas placé sous atmosphère neutre, par exemple avec un gaz inerte à une pression proche de l'atmosphère. Ce sas permet alors de remplir des creusets destinés à être introduit dans la chambre de chargement avec des matériaux qui s'oxydent à l'air libre, tels que les matériaux organiques par exemple.

Comme pour l'enceinte externe 11 de la cellule d'évaporation 10, il est prévu, sur les faces internes de l'enceinte de confinement 202, des éléments chauffants, par exemple des résistances chauffantes 206, destinés à chauffer de façon sensiblement homogène le volume intérieur 209 de l'enceinte de chargement, et en particulier les différents éléments qui peuvent s'y trouver comme les creusets 110, 120.

L'enceinte de confinement 202 de la chambre de chargement 200 comprend sur sa paroi supérieure une ouverture située en regard de l'ouverture d'insertion 12 portant la chambre d'évaporation 100, de sorte que la chambre de chargement 200 est en communication avec la chambre d'évaporation 100 au travers de cette ouverture d'insertion 12 lorsque celle-ci n'est pas obturée.

La chambre de chargement 200 comporte par ailleurs une pompe additionnelle 222 branchée sur l'enceinte de confinement 202 *via* un conduit de pompage 221 pour mettre sous vide ladite chambre de chargement 200, par exemple lorsque celle-ci a été remise à l'air par l'ouverture de la trappe d'accès 201.

Dans la chambre de chargement 200, il est par ailleurs prévu des moyens de chargement et de déchargement des creusets 110, 120, ici un système de carrousel et piston.

Plus précisément, la chambre de chargement 200 comporte tout d'abord un piston 212A à l'extrémité supérieure duquel est fixé un plateau 212 destiné à accueillir le premier creuset 110 ou le deuxième creuset 120.

Le piston 212A est mobile en translation verticale, de sorte que le plateau 212 peut monter et descendre le long de l'axe du piston 212A, entre :
- une position « basse » (cas des figures 2, 6, et 7) dans laquelle le plateau 212 est proche de la paroi inférieure de l'enceinte de confinement 202, et
- une position « haute » (cas des figures 3, 4, 5, 8, 10, 11, et 12) dans laquelle le plateau 212 se situe au niveau de l'ouverture d'insertion 12 de la cellule d'évaporation 10.

La position basse permet le chargement ou le déchargement du plateau 212 avec un creuset 110, 120.

Une fois le creuset 110, 120 en place sur le plateau 212, celui-ci peut monter verticalement grâce au piston 212A et engager ainsi le creuset 110, 120 avec la chambre d'évaporation 100 en passant au travers de l'ouverture d'insertion 12 de la cellule d'évaporation 10.

La chambre de chargement 200 comporte également un carrousel 211 monté sur un axe de rotation 211 A permettant d'entraîner en rotation le carrousel 211.

Ce carrousel 211 est destiné à recevoir les creusets 110, 120 pour leur chargement et leur déchargement du plateau 212.

Le système de carrousel 211 et plateau 212 est particulièrement avantageux car il offre un encombrement réduit pour un nombre de creusets donné. Ainsi, la taille de chambre de chargement 200 et les capacités de pompage de la pompe additionnelle 222 branchée sur la chambre de chargement 200 peuvent être limitées.

Comme représenté sur la figure 2B, il est prévu des moyens de blindage thermique qui s'interposent entre l'enceinte externe 11 de la cellule d'évaporation 10 et la chambre de chargement 200.

Plus précisément, ces moyens de blindage thermique comprennent ici une bride de connexion 17 permettant l'accroche de la paroi inférieure 11C de l'enceinte externe 11 à la paroi supérieure de la chambre de chargement 200. Cette bride de connexion 17 présente une ouverture de connexion 17A coaxiale avec l'ouverture d'insertion 12 et comporte un réseau de serpentins 17B parcourus par un liquide de refroidissement (eau, azote, etc...).

Cette bride de connexion 17 permet notamment d'isoler thermiquement la chambre d'évaporation 100 de la chambre de chargement 200. et d'éviter que la chaleur dégagée par les différents moyens de chauffage 16 de la cellule d'évaporation 10 n'ait un effet perturbateur sur un creuset 110, 120 placé dans la chambre de chargement 200, et *vice versa* afin de ne pas perturber le gradient thermique dans le creuset 110, 120 en cours d'évaporation.

De cette façon, il est possible de retirer «à chaud » le premier creuset 110 de la chambre d'évaporation 100 lorsqu'il est chaud, sans attendre son refroidissement. Le deuxième creuset 120 peut ainsi être introduit dans la chambre d'évaporation 100 dès le retrait du premier creuset 110, et l'évaporation peut reprendre dès la mise à température de ce deuxième creuset 120.

Par ailleurs, grâce aux moyens de blindage thermique 17, il est possible de charger le deuxième creuset 120 dans la chambre de chargement 200 pendant que l'évaporation du premier creuset 110 est en cours, et ce malgré la chaleur dégagée par les moyens d'évaporation 131, 132 qui chauffent le premier creuset 110. Cette chaleur dégagée est sans effet thermique notable et néfaste sur le deuxième creuset 120 se trouvant dans la chambre de chargement 200. En particulier, la température du matériau 7 à évaporer présent dans le creuset 120 reste inférieure à la température d'évaporation du matériau 7.

Pour mettre en oeuvre le procédé de rechargement selon l'invention, il est enfin prévu des moyens d'obturation de l'ouverture d'insertion 12 de la cellule d'évaporation 10 qui, avantageusement, sont mis en oeuvre lors de l'engagement d'un creuset 110, 120 avec la chambre d'évaporation.

Dans les exemples de réalisation représentés sur les figures 2 à 8 et 10 à 12, ces moyens d'obturation comprennent un joint 117, 127 torique fixé le long de la paroi latérale 111, 121 des creusets 110, 120, dans la partie inférieure de celle-ci, proche du fond 115, 125 du creuset 110, 120.

Le diamètre extérieur du joint 117, 127 est choisi de sorte que, lorsqu'un creuset 110, 120 est inséré dans la chambre d'évaporation 100 grâce au piston 212A et au plateau 212 de la chambre de chargement 200, le joint 117, 127 vient en contact avec le corps 101 de la chambre d'évaporation 100.

De cette façon, lorsqu'un creuset 110, 120 est chargé à l'intérieur de la chambre d'évaporation 100, le joint 117, 127 permet d'assurer l'étanchéité de la chambre d'évaporation 100 par rapport à la chambre de chargement 200.

En d'autres termes, grâce au joint 117, 127 prévu sur les creusets 110, 120, il est possible lors de l'engagement d'un creuset 110, 120 avec la chambre d'évaporation 100, d'isoler la chambre de chargement 200 vis-à-vis de la chambre d'évaporation 100.

Dans un autre exemple de réalisation représenté sur les figures 9A et 9B, les moyens d'obturation comprennent un joint 212B attaché au bord périphérique du plateau 212.

De la même manière que précédemment, le diamètre extérieur du joint 212B est choisi de sorte que, lorsqu'un creuset (le premier creuset 110 dans le cas des figures 9A et 9B) est inséré dans la chambre d'évaporation 100 grâce au piston 212A et au plateau 212 de la chambre de chargement 200, le joint 212B vient en contact avec le corps 101 de la chambre d'évaporation 100 de manière à fermer de manière étanche l'ouverture d'insertion 12 de la cellule d'évaporation 10.

Comme le montre la figure 10, on peut également prévoir une vanne 17 placée sur le conduit d'injection 14 de la cellule d'évaporation 10.

De manière avantageuse, cette vanne 17 peut être par exemple une vanne étanche *« tout-ou-rien* » avec deux positions ouverte et fermée qui permet en position fermée, lorsque la chambre d'évaporation 100 est vide, d'éviter que le flux de vapeur ne revienne vers la chambre d'évaporation 100 et n'aille vers la chambre de chargement 200 plus froide pour se condenser sur les parois intérieures de l'enceinte de chargement 202.

En variante, on pourrait prévoir deux vannes placées en série sur le conduit d'injection : une première vanne étanche de type « tout-ou-rien » et une deuxième vanne de régulation en aval de la première vanne étanche.

Bien que le débit du flux de vapeur en sortie de la chambre d'évaporation soit réglé grâce aux moyens d'évaporation, cette vanne de régulation peut également permettre de régler encore plus finement le débit de vapeur de matériau 7.

De préférence, ces vannes sont placées dans l'enceinte externe 11 de la cellule d'évaporation 10 de manière à être chauffées lors de leur utilisation afin éviter les problèmes de condensation dans ces vannes.

On va maintenant décrire, en référence aux figures 2 à 8, un exemple de mise en oeuvre du procédé de rechargement de la cellule d'évaporation 10 de l'appareil de dépôt sous vide 1.

On comprendra à la lumière de la description qui va suivre les avantages d'un tel procédé de rechargement afin de réduire les temps d'arrêt de l'appareil de dépôt sous vide 1.

On considérera ici, comme représenté sur la figure 2A que l'appareil de dépôt sous vide 1 est en cours de fonctionnement et que :
- un premier creuset 110 est engagé avec la chambre d'évaporation 100 de la cellule d'évaporation 10 et chauffé par les moyens d'évaporation 131, 132 de manière à générer un flux de vapeur 116 au travers de l'orifice de sortie 103 de la chambre d'évaporation 100, et
- un précédent creuset 130, dont le contenu a déjà été évaporé, se trouve à l'intérieur de la chambre de chargement 200.

À cet instant, comme expliqué précédemment, la chambre de dépôt sous vide 20, l'enceinte externe 11 qui est en communication directe avec la chambre de dépôt sous vide 20, et la chambre d'évaporation 100 sont à une pression sensiblement identique, proche d'un niveau de vide, compris entre 10⁻³ et 10⁻⁸ Torr.

Le premier creuset 110, qui est engagé dans la chambre d'évaporation 100 de la cellule d'évaporation 10, permet grâce à son joint 117 d'isoler la chambre de chargement 200 vis-à-vis de la chambre d'évaporation 100 attenante et de la chambre de dépôt sous vide 20.

Il est donc possible de remettre à l'air la chambre de chargement 200 sans impacter le vide de la chambre de dépôt sous vide 20.

Aussi, dans une étape de chargement du procédé, on ouvre la trappe d'accès 201 de la chambre de chargement 200 afin de retirer le creuset 130 précédemment vidé. La pression dans la chambre de chargement 200 est alors sensiblement supérieure à celle régnant dans la chambre de dépôt sous vide 20, typiquement proche de 1 atmosphère.

On introduit alors depuis l'extérieur de la cellule d'évaporation 10, éventuellement depuis un sas, généralement appelé « boîte à gant », sous atmosphère neutre, le deuxième creuset 120 à l'intérieur de la chambre de chargement 200 au travers de la trappe d'accès 201, et on dépose ce deuxième creuset 120 sur le carrousel 211 de la chambre de chargement 200.

Après l'étape d'introduction du deuxième creuset 120 dans la chambre de chargement 200, on procède à une étape de confinement de celle-ci.

Cette étape de confinement est destinée à ramener la pression à l'intérieur de la chambre de chargement 200 à un niveau comparable à celui de la chambre d'évaporation 100 pendant l'évaporation du premier creuset 110, à savoir environ 10⁻³ à 10⁻⁸ Torr.

Lors de cette étape de confinement, on ferme alors la trappe d'accès 201 de la chambre de chargement 200 de manière étanche vis-à-vis de l'extérieur de la cellule d'évaporation 10, et grâce à la pompe additionnelle 222, on réalise un pompage à l'intérieur de la chambre de chargement 200 de façon à atteindre le niveau de pression précité.

Les niveaux de pression dans la chambre de chargement 200 et dans la chambre d'évaporation 100 sont alors comparables, de sorte que le plateau 212 supportant le premier creuset 110 peut être retiré sans effort important et sans risque de casse.

Pendant les étapes de chargement et de confinement, on comprend que le flux de vapeur 116 généré par le premier creuset 110 chauffé par les résistances électriques 131 et l'écran thermique 132, ne s'interrompt pas et donc que le niveau du matériau 7 dans le premier creuset 110 baisse (cas des figures 3 et 4) jusqu'à ce que le premier creuset 110 soit vide (cas de la figure 5) ou jusqu'à ce que le niveau de matériau 7 dans le premier creuset 110 soit inférieur à un seuil minimal prédéterminé.

On peut alors libérer le premier creuset 110 d'avec la chambre d'évaporation 100 grâce à l'actionnement du piston 212A vers la bas qui permet au premier creuset 110 d'être transféré de la chambre d'évaporation 100 vers la chambre de chargement 200.

En d'autres termes, lors de l'étape de libération, on retire le premier creuset 110 de la chambre d'évaporation 100 en le faisant passer au travers de l'ouverture d'insertion 12 de la cellule d'évaporation 10 qui met en communication la chambre de chargement 200 et la chambre d'évaporation 100.

On se trouve alors dans la situation représentée sur la figure 6 où le premier creuset 110, vide, repose sur le plateau 212 en position basse, et où le deuxième creuset 120, plein, se trouve sur le carrousel 211 de chargement.

Par rotation du carrousel 211 (voir figure 7), il est alors possible d'intervertir le premier creuset 110 avec le deuxième creuset 120, de sorte que celui-ci est positionné sur le plateau 212 de la chambre de chargement 200.

Le deuxième creuset 120 peut alors être engagé avec la chambre d'évaporation 100 par actionnement du piston 212A vers le haut.

Le deuxième creuset 120 est ainsi inséré dans la chambre d'évaporation 100 au travers de l'ouverture d'insertion 12 (voir figure 8).

On notera ici que, grâce au joint 127 attaché au corps 121 du deuxième creuset 120, l'étape d'engagement du deuxième creuset permet d'obturer l'ouverture d'insertion 12 de manière étanche de sorte que l'étape d'engagement entraîne l'isolement de la chambre de chargement 200 vis-à-vis de la chambre d'évaporation 100 de la cellule d'évaporation, et également de la chambre de dépôt sous vide 20 de l'appareil de dépôt sous vide 1.

Comme expliqué précédemment pour le premier creuset 110, une fois l'isolement assuré par l'engagement du deuxième creuset 120, il est alors possible de décharger le premier creuset 110 de la chambre de chargement 200, par exemple pour introduire un ou plusieurs nouveaux creusets pleins, pour le rechargement de la cellule d'évaporation 20.

Une fois engagé avec la chambre d'évaporation 100 (cf. figure 8), le deuxième creuset 120 peut être mis en conditions d'évaporation grâce aux moyens d'évaporation pour générer un flux de vapeur 126 du matériau au travers de l'orifice de sortie de la chambre d'évaporation 100.

On comprend donc que le procédé de rechargement selon l'invention permet de réduire la durée pendant laquelle le flux de vapeur de matériau est interrompu. En effet, cette interruption est limitée dans le temps par les opérations de libération du premier creuset 110 et d'engagement et de mise en conditions d'évaporation du deuxième creuset 120. Les creusets 110, 120 étant de petit volume, leur mise en conditions d'évaporation peut être rapide car la quantité de matériau 7 à chauffer est limitée.

En ce sens, on peut considérer que le procédé de rechargement de la cellule d'évaporation 10 selon l'invention permet à l'appareil de dépôt sous vide 1 de fonctionner selon un régime de production *quasi* continu.

Avantageusement, il est d'ailleurs possible, avant l'engagement du deuxième creuset 120 avec la chambre d'évaporation 100, de préparer le deuxième creuset 120 placé alors dans la chambre de chargement 200 afin de diminuer encore plus la durée d'interruption du flux de vapeur.

Cette étape de préparation est destinée à réduire la durée de l'étape de mise en conditions d'évaporation du deuxième creuset 120.

Plus particulièrement ici, on réalise grâce aux moyens de chauffage 206 de la chambre de chargement 200 un préchauffage du deuxième creuset 120 jusqu'à une température de préchauffage prédéterminée.

De préférence, la puissance des moyens de chauffage est ajustée pour que la température de préchauffage soit inférieure à la température d'évaporation du matériau 7 contenu dans le deuxième creuset 120 de manière à empêcher le début de l'évaporation dudit matériau 7.

Bien que le procédé de rechargement selon l'invention ait été décrit avec seulement un seul creuset en attente dans la chambre de chargement, il peut facilement se mettre en oeuvre avec plusieurs creusets.

Par exemple, lors de l'étape de rechargement, il est possible d'introduire autant de creusets que le carrousel peut en accueillir. Dans ce cas, l'ouverture de la trappe d'accès de la chambre de chargement et l'utilisation de la pompe additionnelle sont moins fréquentes et les conditions de température et de pression dans la chambre de chargement sont plus stables. À chaque changement d'un creuset vide, on insère un des creusets pleins restant sur le carrousel. Lorsque tous les creusets présents sur le carrousel sont vides (un creuset étant en cours d'évaporation dans la chambre d'évaporation)

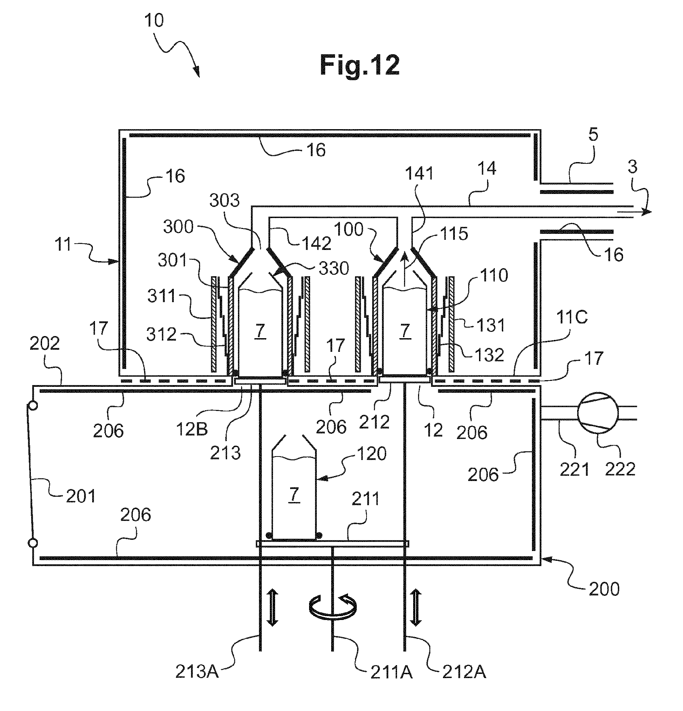

Par ailleurs, comme représenté sur la figure 12, le procédé de rechargement selon l'invention peut être mis en oeuvre pour un appareil de dépôt sous vide 1 avec une cellule d'évaporation 10 comportant deux chambres d'évaporation 100, 300.

On comprendra à la lumière de la description qui va suivre qu'une production continue de vapeur de matériau par la cellule d'évaporation est possible.

Dans l'exemple décrit ici, ces deux chambres d'évaporation 100, 300 sont identiques à la chambre d'évaporation 100 précédemment décrite (cf. figures 2 à 11) et les moyens d'évaporation 131, 132, 311, 312 respectifs sont également identiques. Les chambres d'évaporation 100, 300 sont montées en parallèle sur le conduit d'injection 14 respectivement grâce à des portions 141, 142 de conduit branchées sur les orifices de sortie 103, 303 desdites chambres d'évaporation 100, 300.

Entre les deux chambres d'évaporation 100, 300 sont disposés dans la cellule d'évaporation 10, des écrans thermiques en matériau réfractaire tel que l'aluminium afin de rendre thermiquement indépendantes ces deux chambres d'évaporation 100, 300.

L'enceinte externe 11 de la cellule d'évaporation 10 comporte deux ouvertures d'insertion 12, 12B permettant l'engagement et le désengagement des creusets.

En correspondance, l'enceinte de confinement 202 de la chambre de chargement 200 comprend sur sa paroi supérieure deux ouvertures situées en regard de ces ouvertures d'insertion 12, 12B, de sorte que la chambre de chargement 200 est respectivement en communication avec la première chambre de d'évaporation 100 et la deuxième chambre de chargement 300 au travers de la première ouverture d'insertion 12 et de la deuxième ouverture d'insertion 12B, lorsque celles-ci ne sont pas obturées.

Par ailleurs, la chambre de chargement 200 comporte, en plus du carrousel 211 et du premier plateau 212, un deuxième plateau 213 associé à son piston 213A, qui permet la libération et l'insertion d'un creuset dans la deuxième chambre d'évaporation 300. Le carrousel 211 est agencé dans la chambre de chargement 200 de manière à pouvoir déposer un creuset sur l'un ou l'autre des plateaux 212, 213.

On va maintenant décrire le procédé de rechargement selon l'invention et voir comment celui-ci permet une production continue.

On considère ici que la situation initiale de la cellule d'évaporation est celle représentée sur la figure 12 :
- un premier creuset 110, presque vide, placé dans la première chambre d'évaporation 100, est en cours d'évaporation et génère un flux de vapeur 116 de matériau 7 au travers de l'orifice de sortie 103, flux de vapeur 116 conduit ensuite vers l'injecteur 13 (non représenté) grâce à la portion 141 de conduit et au conduit d'injection 14 ;
- un deuxième creuset 120, plein, placé dans la chambre de chargement 200 mise sous vide grâce à la pompe additionnelle 222, est en attente sur le carrousel 211 et préchauffé par les moyens de chauffage 206 de la chambre de chargement 200 ;
- un troisième creuset 330, plein, engagé avec la deuxième chambre d'évaporation 300, est progressivement mis en conditions d'évaporation grâce aux résistances électriques 311 chauffant le troisième creuset 330 au travers de l'écran thermique 312 et du corps 301 de la chambre d'évaporation 300.

De manière avantageuse, il est prévu que le troisième creuset 330 engagé avec la deuxième chambre d'évaporation 300 commence son évaporation lorsque la quantité de matériau 7 à évaporer restante dans le premier creuset 110 est inférieure à un seuil minimal prédéterminé, de manière à maintenir un débit constant pour le flux de matériau conduit dans le conduit d'injection 14 vers l'injecteur 13.

On peut également prévoir de monter des vannes étanches de type « tout-ou-rien » et/ou des vannes de régulation sur les portions 141, 142 du conduit d'injection 13, soit pour réguler le flux de vapeur à l'intérieur du conduit d'injection, soit pour empêcher que le flux de vapeur sortant de l'une des chambres d'évaporation ne pollue l'autre chambre d'évaporation.

Lorsque le premier creuset 110 est vide ou lorsque la quantité de matériau 7 à évaporer restante dans le premier creuset 110 est inférieure à une limite basse prédéterminée (cette limite basse étant inférieure au seuil minimal précédent), on procède à son remplacement par rechargement de la cellule d'évaporation 10. À ce moment-là, la deuxième chambre d'évaporation 300 prend le relais, le flux de vapeur généré par le troisième creuset 330 étant dirigé vers l'injecteur 13, de sorte que le débit de vapeur injectée dans la chambre de dépôt sous vide 20 n'est pas interrompu.

Lors de ce rechargement, on libère le premier creuset 110 de la première chambre d'évaporation 100 en le faisant passer au travers de la première ouverture d'insertion 12 grâce au plateau 212.

Ensuite, on décharge le premier creuset 110 du plateau 212 sur le carrousel 211 et on charge le deuxième creuset 120 du carrousel 211 sur le plateau 212.

On engage alors le deuxième creuset 120 avec la première chambre d'évaporation 100 et on le met progressivement en conditions d'évaporation afin que, lorsque la quantité de matériau 7 à évaporer restante dans le troisième creuset 110, qui est en cours d'évaporation dans la deuxième chambre d'évaporation 300, est inférieure au seuil minimal prédéterminé.

Une fois le deuxième creuset 120 engagé avec la première chambre d'évaporation 100, la chambre de chargement 200 est isolée des deux chambres d'évaporation 100, 300, et également de la chambre de dépôt sous vide 20.

Il est alors temps d'ouvrir la trappe d'accès 201 de la chambre de chargement 200 pour retirer le premier creuset 110 et introduire un quatrième creuset (non représenté) dans la chambre de chargement 200 remise à l'air, la pression dans la chambre de chargement 200 étant alors sensiblement supérieure à celle régnant dans la chambre de dépôt sous vide 20.

Enfin, on peut procéder à l'étape de confinement de la chambre de chargement 200 pour ramener la pression à l'intérieur de cette chambre de chargement 200 à un niveau comparable à celui des chambres d'évaporation 100, 300.

Lorsque le troisième creuset 330 vient à se vider, on peut mettre en oeuvre, selon le procédé de rechargement selon l'invention, les étapes de libération du troisième creuset 330, et d'engagement et de mise en conditions d'évaporation du quatrième creuset engagé avec la deuxième chambre d'évaporation 300.

Ainsi, en mettant le procédé de rechargement selon l'invention avec une cellule d'évaporation comportant au moins deux chambres d'évaporation et une chambre de chargement attenante auxdites chambres d'évaporation, il est possible de ne jamais interrompre le flux de vapeur de matériau transporté jusqu'à l'injecteur pour être injecté dans la chambre de dépôt sous vide de l'appareil de dépôt sous vide. Il est donc possible de prévoir une production en continue, avec un défilement de substrats en regard dudit injecteur.

De manière à limiter la fréquence de rechargement de la cellule d'évaporation, on peut prévoir avantageusement dans l'enceinte externe de la cellule d'évaporation un barillet comportant un grand nombre de chambres d'évaporation, pourvue chacune de leurs propres moyens d'évaporation et éventuellement de leur propre système de vannes en sortie desdites chambres.

Ce barillet peut être chargé en une seule fois au moyen d'un « chargeur » réunissant ensemble un nombre de creusets correspondant au nombre de chambres d'évaporation, la mise en place du chargeur permettant d'engager simultanément tous les creusets dans leur chambre d'évaporation respective.

Le procédé de rechargement de la cellule d'évaporation comprend alors :
- une étape de chargement d'un deuxième chargeur, réunissant une pluralité de creusets contenant chacun le matériau à évaporer, dans une chambre de chargement préalablement isolée desdites chambres d'évaporation attenantes du barillet, la pression dans de ladite chambre de chargement étant alors sensiblement supérieure à celle régnant dans la chambre de dépôt sous vide,
- après ladite étape d'introduction, une étape de confinement de ladite chambre de chargement destinée à ramener la pression à l'intérieur de ladite chambre de chargement à un niveau comparable à celui des chambres d'évaporation du barillet,
- après ladite étape de confinement, une étape de libération dudit premier chargeur d'avec ledit barillet lors de laquelle ledit premier chargeur transféré dudit barillet vers ladite chambre de chargement,
- après ladite étape de libération du premier chargeur, une étape d'engagement dudit deuxième chargeur avec ledit barillet de chambres d'évaporation, et
- après ladite étape d'engagement dudit deuxième creuset, une étape de mise en conditions d'évaporation desdits creusets du deuxième chargeur.

## Revendications

1. Procédé de rechargement d'une cellule d'évaporation (10) destinée à évaporer un matériau (7) en vue de son dépôt sur un substrat (2) placé dans une chambre de dépôt sous vide (20), un premier creuset (110) contenant ledit matériau (7) à évaporer étant engagé avec une chambre d'évaporation (100) de ladite cellule d'évaporation (10), des moyens d'évaporation (101, 131, 132) étant prévus pour mettre ledit premier creuset (110) en conditions d'évaporation pour générer un flux de vapeur (116) du matériau (7) au travers d'un orifice de sortie (103) de ladite chambre d'évaporation (100), ledit orifice de sortie (103) étant raccordé à un injecteur (13) pour l'injection de ladite vapeur dans ladite chambre de dépôt sous vide (20),
ledit procédé de rechargement comportant :
- une étape de chargement d'un deuxième creuset (120) contenant le matériau (7) à évaporer dans une chambre de chargement (200) préalablement isolée de ladite chambre d'évaporation (100) attenante, la pression dans ladite chambre de chargement (200) étant alors sensiblement supérieure à celle régnant dans la chambre de dépôt sous vide (20),
- après ladite étape d'introduction, une étape de confinement de ladite chambre de chargement (200) destinée à ramener la pression à l'intérieur de ladite chambre de chargement (200) à un niveau comparable à celui de ladite chambre d'évaporation (100) lors de l'évaporation dudit premier creuset (110),
- après ladite étape de confinement, une étape de libération dudit premier creuset (110) d'avec ladite chambre d'évaporation (100) lors de laquelle ledit premier creuset (110) est transféré de ladite chambre d'évaporation (100) vers ladite chambre de chargement (200),
- après ladite étape de libération du premier creuset (110), une étape d'engagement dudit deuxième creuset (120) avec ladite chambre d'évaporation (100), et
- après ladite étape d'engagement dudit deuxième creuset (120), une étape de mise en conditions d'évaporation dudit deuxième creuset (120) pour générer un flux de vapeur (126) du matériau (7) au travers dudit orifice de sortie (103) de la chambre d'évaporation (100),
**caractérisé en ce que** lors de ladite étape d'engagement dudit deuxième creuset (120), on isole ladite chambre de chargement (200) vis-à-vis de ladite chambre d'évaporation (100) et de ladite chambre de dépôt sous vide (20).

2. Procédé de rechargement selon la revendication 1, selon lequel lors de ladite étape de chargement dudit deuxième creuset (120), on ouvre une trappe d'accès (201) de ladite chambre de chargement (200) et on introduit, depuis l'extérieur de ladite cellule d'évaporation (10), ledit deuxième creuset (120) à l'intérieur de ladite chambre de chargement (200) au travers de ladite trappe d'accès (201).

3. Procédé de rechargement selon la revendication 2, selon lequel lors de ladite étape de confinement, on ferme ladite trappe d'accès (201) de manière étanche vis-à-vis de l'extérieur de ladite cellule d'évaporation (10), et on réalise un pompage à l'intérieur de ladite chambre de chargement (200).

4. Procédé de rechargement selon l'une des revendications 1 à 3, selon lequel :
- lors de ladite étape de libération du premier creuset (110), on retire ledit premier creuset (110) de ladite chambre d'évaporation (100) en le faisant passer au travers d'une ouverture d'insertion (12) mettant en communication ladite chambre de chargement (200) et ladite chambre d'évaporation (100), et
- lors de ladite étape d'engagement dudit deuxième creuset (120), on insère ledit deuxième creuset (120) dans ladite chambre d'évaporation (100) en le faisant passer au travers de ladite ouverture d'insertion (12), et on obture ladite ouverture d'insertion (12) de manière étanche pour isoler ladite chambre de chargement (200) de ladite chambre d'évaporation (100).

5. Procédé de rechargement selon l'une des revendications 1 à 4, comportant, avant ladite étape d'engagement dudit deuxième creuset (120) avec ladite chambre d'évaporation (100), une étape de préparation dudit deuxième creuset (120) dans ladite chambre de chargement (200) destinée à réduire la durée de ladite étape de mise en conditions d'évaporation dudit deuxième creuset (120).

6. Procédé de rechargement selon la revendication 5, selon lequel ladite étape de préparation comprend une étape de préchauffage dudit deuxième creuset (120) dans ladite chambre de chargement (200), jusqu'à une température de préchauffage prédéterminée.
